# EUROPEAN PATENT APPLICATION

(11) **EP 4 318 611 A1**
(43) Date of publication of application: **07.02.2024**
(21) Application number: 22913564.5
(22) Date of filing: 23.09.2022
(51) Int. Cl.: H01L 31/18, H01L 31/0216, C23C 16/24

(54) **SOLAR CELL PANEL, CELL PIECE AND PRODUCTION PROCESS FOR CELL PIECE**

(30) Priority: 31.12.2021 CN 202111675167
(71) Applicant: Tongwei Solar (Meishan) Co., Ltd., Meishan, Sichuan 620041 (CN)
(72) Inventor: XU, Wenzhou, Sichuan 620041 (CN); MENG, Xiajie, Sichuan 620041 (CN); YAO, Qian, Sichuan 620041 (CN); WANG, Xiupeng, Sichuan 620041 (CN); XING, Guoqiang, Sichuan 620041 (CN)
(74) Representative: Marks & Clerk LLP
(86) International application number: PCT/CN2022/120749
(87) International publication number: WO 2023/124299

(57) **Abstract**

The present application relates to a solar cell panel, a cell piece and a production process for a cell piece. A silicon oxide layer (200) is formed on the back surface of an N-type silicon wafer (100); an N-type silicon layer (300) is formed on the silicon oxide layer (200), wherein the phosphine concentration of the N-type silicon layer (300) is within a first preset concentration range; and an antireflection layer (400) is formed on the N-type silicon layer (300) and a back electrode (500) is formed on the antireflection layer (400). In the high-temperature annealing process, hydrogen atoms can be bound by phosphine, such that membrane explosion caused by the escape of hydrogen atoms is avoided, an open-circuit voltage, the conversion efficiency and a filling factor can be improved, a back passivation effect can be enhanced, and the quality of a cell piece can be improved.

## Description

### RELATED APPLICATIONS

This application claims priority to Chinese Patent Application No. 2021116751674, entitled "SOLAR CELL PANEL, CELL PIECE AND PRODUCTION PROCESS FOR CELL PIECE", filed on December 31, 2021, the content of which is incorporated herein by reference in its entirety.

### TECHNICAL FIELD

The present disclosure relates to the field of photovoltaic technologies, particularly relates to a solar cell panel, a cell piece and a process for producing the cell piece.

### BACKGROUND

In the production of cell piece of solar cell panel, conventional methods include depositing ultra-thin intrinsic polycrystalline silicon with a certain thickness on a tunnel oxide layer on a backside of a N-type silicon wafer, and then preparing a doped N-type polycrystalline silicon by in-situ introduction of phosphine, so as to achieve an effect of backside selective passivation.

When the doped N-type polycrystalline silicon is prepared by PECVD (Plasma Enhanced Chemical Vapor Deposition), a large amount of hydrogen is introduced to enhance the passivation effect. However, in the subsequent high-temperature annealing process, hydrogen atoms will escape, resulting in a film explosion phenomenon. Especially on polished pieces or polished and then textured cell pieces, the film explosion is more likely to occur after high-temperature annealing. When observed with microscope, there can be more than 200 film explosion points within 1 mm², and the diameter of film explosion is about 1 um to 8 um. Meanwhile, the points of film explosion can be defective and cause recombination of a large number of carriers, which reduces the passivation effect and lowers the open-circuit voltage of the solar cell panel.

### SUMMARY

According to various embodiments of the present disclosure, on one hand, a process for producing cell piece is provided, including the following steps:
forming a silicon oxide layer on a backside of an N-type silicon wafer;
forming an N-type silicon layer on the silicon oxide layer, and a phosphine concentration of the N-type silicon layer is within a first preset concentration range; and
forming an anti-reflection layer on the N-type silicon layer and forming a backside electrode on the anti-reflection layer.

In one embodiment, the step of forming the N-type silicon layer on the silicon oxide layer includes:
forming a first N-type silicon layer on the silicon oxide layer, and a phosphine concentration of the first N-type silicon layer is within the first preset concentration range; and
forming a second N-type silicon layer on the first N-type silicon layer, and a phosphine concentration of the second N-type silicon layer is within the first preset concentration range, and the phosphine concentration of the second N-type silicon layer is greater than the phosphine concentration of the first N-type silicon layer.

In one embodiment, the step of forming the second N-type silicon layer on the first N-type silicon layer includes:
the phosphine concentration of the second N-type silicon layer is at least twice the phosphine concentration of the first N-type silicon layer.

In one embodiment, the step of forming the first N-type silicon layer on the silicon oxide layer, and the phosphine concentration of the first N-type silicon layer is within the first preset concentration range includes: introducing a phosphine of less than or equal to 1000 sccm.

In one embodiment, the step of forming the first N-type silicon layer on the silicon oxide layer, and the phosphine concentration of the first N-type silicon layer is within the first preset concentration range includes: introducing a phosphine of greater than or equal to 500 sccm and less than or equal to 1000 sccm.

In one embodiment, the step of forming the second N-type silicon layer on the silicon oxide layer, and the phosphine concentration of the second N-type silicon layer is within the first preset concentration range, and the phosphine concentration of the second N-type silicon layer is greater than the phosphine concentration of the first N-type silicon layer includes: introducing a phosphine of greater than or equal to 2000 sccm.

In one embodiment, the step of forming the second N-type silicon layer on the silicon oxide layer, and the phosphine concentration of the second N-type silicon layer is within the first preset concentration range, and the phosphine concentration of the second N-type silicon layer is greater than the phosphine concentration of the first N-type silicon layer includes: introducing a phosphine of greater than or equal to 2500 sccm.

In one embodiment, the step of forming the first N-type silicon layer on the silicon oxide layer, and the phosphine concentration of the first N-type silicon layer is within the first preset concentration range includes: the phosphine concentration of the first N-type silicon layer increases with an increase in a thickness of the first N-type silicon layer.

In one embodiment, the step of forming the second N-type silicon layer on the silicon oxide layer, and the phosphine concentration of the second N-type silicon layer is within the first preset concentration range, and the phosphine concentration of the second N-type silicon layer is greater than the phosphine concentration of the first N-type silicon layer includes: the phosphine concentration of the second N-type silicon layer increases with an increase in a thickness of the second N-type silicon layer.

In one embodiment, the step of forming the N-type silicon layer on the silicon oxide layer, and the phosphine concentration of the N-type silicon layer is within the first preset concentration range includes:
a concentration of silane introduced during the formation of the first N-type silicon layer is the same as a concentration of silane introduced during the formation of the second N-type silicon layer, the silane concentration is greater than the phosphine concentration of the first N-type silicon layer, and the silane concentration is less than the phosphine concentration of the second N-type silicon layer.

In one embodiment, the step of forming the N-type silicon layer on the silicon oxide layer includes:
introducing the silane of greater than or equal to 1200 sccm and less than or equal to 1800 sccm.

In one embodiment, the step of the concentration of silane introduced during the formation of the first N-type silicon layer is the same as the concentration of silane introduced during the formation of the second N-type silicon layer further includes: introducing methane, and a methane concentration is less than or equal to three times of the silane concentration.

In the other aspect of the present disclosure, a cell piece is provided, which is produced by the production process.

In one embodiment, the cell piece includes:
an N-type silicon wafer having a backside;
a silicon oxide layer provided on the backside; and
an N-type silicon layer provided on a side of the silicon oxide layer away from the N-type silicon wafer, and a phosphine concentration of the N-type silicon layer is within a first preset concentration range, so as to bind hydrogen atom during a high-temperature annealing process.

In one embodiment, the N-type silicon layer includes a first N-type silicon layer and a second N-type silicon layer, the first N-type silicon layer is provided on the side of the silicon oxide layer away from the N-type silicon wafer, the second N-type silicon layer is provided on a side of the first N-type away from the silicon oxide layer, both a phosphine concentration of the first N-type silicon layer and a phosphine concentration of the second N-type silicon layer are within the first preset concentration range, and the phosphine concentration of the second N-type silicon layer is greater than the phosphine concentration of the first N-type silicon layer.

In one embodiment, the phosphine concentration of the first N-type silicon layer increases in a direction of thickness away from the silicon oxide layer.

In one embodiment, the phosphine concentration of the second N-type silicon layer increases in a direction of thickness away from the first N-type silicon layer.

In another aspect of the present disclosure, a solar cell panel including the cell piece is provided.

The details of one or more embodiments of the present disclosure are set forth in the accompanying drawings and the description below. Other features, objects and advantages of the present disclosure will become apparent from the description, the accompanying drawings, and the claims.

### BRIEF DESCRIPTION OF THE DRAWINGS

To illustrate the technical solutions according to the embodiments of the present invention or in the conventional art more clearly, the accompanying drawings for describing the embodiments or the conventional art are introduced briefly in the following. Apparently, the accompanying drawings in the following description are only some embodiments of the present invention, and persons of ordinary skill in the art can derive other drawings from the accompanying drawings without creative efforts.
FIG. 1 is a flow chart of a process for producing a cell piece according to one embodiment of the present disclosure;
FIG. 2 is a flow chart of a process for producing a cell piece according to another embodiment;
FIG. 3 shows a comparison between the conventional method and the process for producing the cell piece according the present disclosure;
FIG. 4 shows a comparison of the cell efficiency and open-circuit voltage of a cell produced in a conventional method with the cell efficiency and open-circuit voltage of a cell produced by the production process according the present disclosure;
FIG. 5 shows an ECV test diagram for the process for producing cell piece according the present disclosure;
FIG. 6 is a schematic view of a cell piece produced by the production process of FIG. 1.

### Reference Numerals:

100, N-type silicon wafer; 200, silicon oxide layer; 300, N-type silicon layer; 310, first N-type silicon layer; 320, second N-type silicon layer; 400, anti-reflection layer; 500, backside electrode.

### DETAILED DESCRIPTION OF EMBODIMENTS

The technical solutions in the embodiments of the present disclosure will be clearly and completely described hereinafter in combination with the accompanying drawings in the embodiments of the present disclosure. Obviously, the described embodiments are only a part of the embodiments of the present disclosure, but not all of the embodiments. All other embodiments obtained by a person of ordinary skill in the art based on the embodiments in the present disclosure without creative efforts are within the scope of the present disclosure.

Conventional processes for producing cell piece include: firstly depositing ultra-thin intrinsic polycrystalline silicon with a certain thickness on the tunnel oxide layer on the backside of the N-type silicon wafer, the intrinsic polycrystalline silicon can prevent phosphine from entering the N-type silicon wafer, thus playing a barrier role; and then preparing a doped N-type polycrystalline silicon by in-situ introduction of phosphine, so as to achieve an effect of backside selective passivation. In order to improve the passivation effect, hydrogen is usually introduced during the preparation of the doped N-type polycrystalline silicon layer. However, in the subsequent high-temperature annealing process, hydrogen may escape when being subjected to heat, thus resulting in the film explosion.

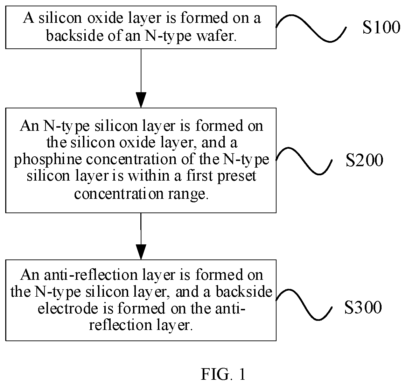

As shown in FIG. 1, in one embodiment, a process for producing a cell piece is provided, including the following steps:
S 100, a silicon oxide layer 200 is formed on a backside of an N-type silicon wafer 100.

In one embodiment, an SiOx tunnel oxide layer 200 is prepared on the backside of the N-type silicon wafer 100.

In addition, the backside of the N-type silicon wafer 100 can be polished or textured after polishing, then the SiOx tunnel oxide layer 200 is prepared on the backside of the N-type silicon wafer 100.

S200, an N-type silicon layer 300 is formed on the silicon oxide layer 200, and a phosphine concentration of the N-type silicon layer 300 is within a first preset concentration range.

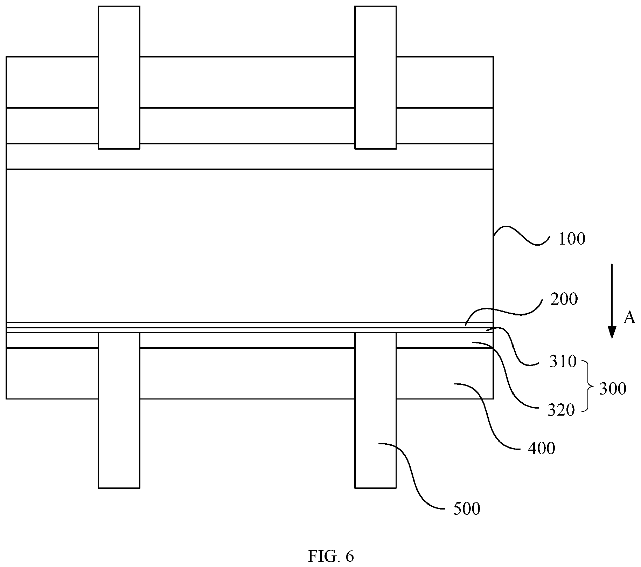

As shown in FIG. 6, optionally, the N-type silicon layer 300 is prepared on a side of the silicon oxide layer 200 away from the N-type silicon wafer 100 by PECVD (Plasma Enhanced Chemical Vapor Deposition), and a certain amount of phosphine is introduced during the preparation of the N-type silicon layer 300, such that the phosphine concentration of the N-type silicon layer 300 is within the first preset concentration range. As such, in the subsequent high-temperature annealing process, since the N-type silicon layer 300 is doped with a certain concentration of phosphine, hydrogen atoms can be bound, and the film explosion caused by diffusion due to escape of hydrogen atoms can be avoided. Therefore, not only the open-circuit voltage, the conversion efficiency, and the filling factor can be increased, but also the back-passivation effect can be improved, thereby improving the quality of the cell piece.

The N-type silicon layer 300 may be in the form of polycrystalline silicon alone, amorphous silicon alone, or a combination of polycrystalline silicon and amorphous silicon, as long as the requirement of doping phosphine of the first preset concentration can be met.

The specific value range or value of the first preset concentration range can be flexibly designed or adjusted according to the actual process conditions or production needs, as long as it meets the requirement that the phosphine can bind hydrogen atoms in the subsequent high-temperature annealing process, which can avoid the film explosion caused by hydrogen atoms escaping.

In addition, when preparing the N-type silicon layer 300, gases, such as methane, hydrogen, nitrous oxide and the like can be introduced to enhance passivation.

Furthermore, prior to preparing the N-type silicon layer 300 on the silicon oxide layer 200, the side of the silicon oxide layer 200 away from the N-type silicon wafer 100 can be polished or textured after polishing, so as to improve the light trapping effect.

Additionally, in conventional production process, intrinsic polycrystalline silicon is prepared on the silicon oxide layer 200, since gases are prone to escape from smooth surface, the hydrogen atoms escape phenomenon is more serious in the subsequent high-temperature annealing process. In the embodiments of the present disclosure, the N-type silicon wafer 100 doped with phosphine is prepared on the silicon oxide layer 200, hydrogen atoms are bound by phosphine, which in turn can avoid the film explosion caused by spillage and diffusion due to escape of hydrogen atoms. Meanwhile, compared with intrinsic polycrystalline silicon, the N-type silicon layer 300 has excellent impurity absorption and blocking effect, and has excellent field passivation effect and electron selective permeability.

S300, an anti-reflection layer 400 is formed on the N-type silicon layer 300, and a backside electrode 500 is formed on the anti-reflection layer 400.

As shown in FIG. 6, optionally, the anti-reflection layer 400 containing silicon nitride is prepared on a side of the N-type silicon layer 300 away from the silicon oxide layer 200, and silver paste is printed on the anti-reflection layer 400 to form the backside electrode 500.

It should be noted that the process for producing the cell piece also includes a process for processing the front side of the N-type silicon wafer 100, which will not be described herein since it can be any one of the conventional processing processes.

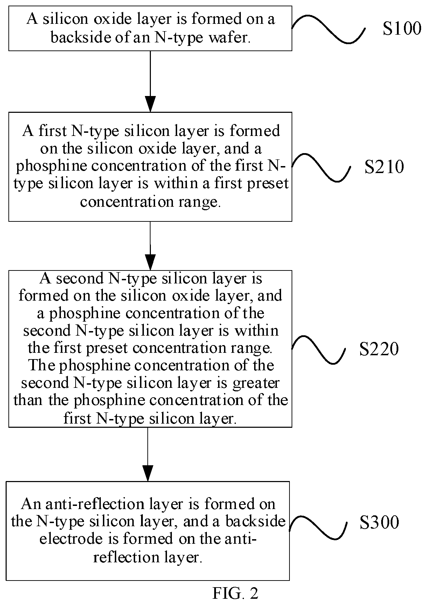

As shown in FIG. 2, optionally, step S200 includes:
S210, a first N-type silicon layer 310 is formed on the silicon oxide layer 200, and a phosphine concentration of the first N-type silicon layer 310 is within a first preset concentration range.

In one embodiment, the N-type silicon layer 310 is prepared on the side of the silicon oxide layer 200 away from the N-type silicon layer 300 by PECVD. A certain amount of phosphine is introduced during the preparation, such that the phosphine concentration of the first N-type silicon layer 310 is within the first preset concentration range.

In one embodiment, during the preparation of the first N-type silicon layer 310, a phosphine of less than or equal to 1000 sccm is introduced, such that the phosphine concentration of the first N-type silicon layer 310 is within the first preset concentration range. As such, in the subsequent high-temperature annealing process, since the first N-type silicon layer 310 is doped with a certain concentration of phosphine, hydrogen atoms can be bound, and the film explosion caused by spillage and diffusion due to escape of hydrogen atoms can be avoided. Therefore, the open-circuit voltage, the conversion efficiency and the filling factor can be increased, thereby improving the quality of the cell piece.

Preferably, a phosphine of greater than or equal to 500 sccm and less than or equal to 1000 sccm is introduced, which can ensure that the phosphine concentration of the first N-type silicon layer 310 can effectively bind hydrogen atoms, thereby effectively avoiding the film explosion caused by spillage and diffusion due to escape of hydrogen atoms.

S220, a second N-type silicon layer 320 is formed on the silicon oxide layer 200, and a phosphine concentration of the second N-type silicon layer 320 is within the first preset concentration range. The phosphine concentration of the second N-type silicon layer 320 is greater than the phosphine concentration of the first N-type silicon layer 310.

In one embodiment, the second N-type silicon layer 320 is prepared on a side of the first N-type silicon layer 310 away from the silicon oxide layer 200 by PECVD. A certain amount of phosphine is introduced during the preparation, such that the phosphine concentration of the second N-type silicon layer 320 is within the first preset concentration range, and the phosphine concentration of the second N-type silicon layer 320 is greater than the phosphine concentration of the first N-type silicon layer 310.

In one embodiment, during the preparation of the second N-type silicon layer 320, a phosphine of greater than or equal than 2000 sccm is introduced, such that the phosphine concentration of the second N-type silicon layer 320 is within the first preset concentration range, and the phosphine concentration of the second N-type silicon layer 320 is greater than the phosphine concentration of the first N-type silicon layer 310. As such, in the subsequent high-temperature annealing process, since the second N-type silicon layer 320 is doped with a certain concentration of phosphine, hydrogen atoms can be bound, and the film explosion caused by spillage and diffusion due to escape of hydrogen atoms can be avoided. Therefore, the open-circuit voltage, the conversion efficiency and the filling factor can be increased, thereby improving the quality of the cell piece.

Preferably, during the preparation of the second N-type silicon layer 320, a phosphine of greater than or equal to 2550 sccm is introduced, which can ensure that the phosphine concentration of the second N-type silicon layer 320 be relatively high, so as to effectively bind hydrogen atoms, thereby effectively avoiding the film explosion caused by spillage and diffusion due to escape of hydrogen atoms.

In addition, compared with the first N-type silicon layer 310, the second N-type silicon layer 320 is more adjacent to the outer side of the cell piece, such that hydrogen ions are more likely to escape during the high-temperature annealing process. Since the phosphine concentration of the second N-type silicon layer 320 is greater than the phosphine concentration of the first N-type silicon layer 310, hydrogen atoms can be well bound, thus ensuring that hydrogen atoms will not escape and cause spillage and diffusion, thereby can effectively avoiding the film explosion.

Optionally, during the preparation of the second N-type silicon layer 320, the phosphine concentration of the second N-type silicon layer 320 is at least twice the phosphine concentration of the first N-type silicon layer 310. On the basis of ensuring the phosphine concentration of the first N-type silicon layer 310 can effectively bind hydrogen atoms, the phosphine concentration of the second N-type silicon layer 320 is relatively high, so as to bind hydrogen atoms in the second N-type silicon layer 320 better, thereby avoiding the film explosion due to escape of hydrogen atoms.

The phosphine concentration of the second N-type silicon layer 320 may be twice, three times, four times or more of the phosphine concentration of the first N-type silicon layer 310.

In the subsequent high-temperature annealing process, the more adjacent to the outer side of the cell piece, the higher the probability that the escape of hydrogen atoms will occur.

Optionally, step S210 further includes: S211, the phosphine concentration of the first N-type silicon layer 310 increases with an increase in a thickness of the first N-type silicon layer 310. As such, when preparing the first N-type silicon layer 310 by PECVD or other methods, the thickness of the first N-type silicon layer 310 increases as time goes by, and the phosphine concentration also increases simultaneously, such that the phosphine concentration of the first N-type silicon layer 310 away from the silicon oxide layer 200 is greater than the phosphine concentration of the first N-type silicon layer 310 adjacent to the silicon oxide layer 200. Therefore, the binding capacity of the first N-type silicon layer 310 to hydrogen atoms is continuously enhanced in a direction away from the silicon oxide layer 200 (as direction A shown in FIG. 6), thus ensuring that all parts of the first N-type silicon layer 310 can effectively bind hydrogen atoms, and the film explosion can be effectively avoided.

In one embodiment, the phosphine concentration increases with the increase in the thickness of the first N-type silicon layer 310 by gradually increasing the supply amount of phosphine.

Optionally, step S220 further includes: S221, the phosphine concentration of the second N-type silicon layer 320 increases with an increase in a thickness of the second N-type silicon layer 320. As such, when preparing the second N-type silicon layer 320 by PECVD or other methods, the thickness of the second N-type silicon layer 320 increases as time goes by, and the phosphine concentration also increases simultaneously, such that the phosphine concentration of the second N-type silicon layer 320 away from the first N-type silicon is greater than the phosphine concentration of the second N-type silicon layer 320 adjacent to the first N-type silicon. Therefore, the binding capacity of the second N-type silicon layer 320 to hydrogen atoms is continuously enhanced in a direction away from the first N-type silicon (as direction A shown in FIG. 6), thus ensuring that all parts of the second N-type silicon layer 320 can effectively bind hydrogen atoms, and the film explosion can be effectively avoided.

In one embodiment, the phosphine concentration increases with the increase in the thickness of the second N-type silicon layer 320 by gradually increasing the supply amount of phosphine. In addition, the phosphine concentration of the second N-type silicon layer 320 is always greater than the phosphine concentration of the first N-type silicon layer 310.

It should be noted that during the actual preparation, the number of the layers of the first N-type silicon layer 310 and the second N-type silicon layer 320 can be flexibly designed or adjusted according to the actual use requirements, as long as it can meet the requirement that hydrogen atoms are bound in the subsequent high-temperature annealing process, so as to avoid the film explosion.

For example, the first N-type silicon layer 310 may be at least two layers (two, three or more layers), the second N-type silicon layer 320 may also be at least two layers (two, three or more layers), and the first N-type silicon layer 310 and the second N-type silicon layer 320 can be alternatively arranged. In other words, one layer of the second N-type silicon layer 320 is located between two adjacent first N-type silicon layers 310, and one layer of the first N-type silicon layer 310 is located between two adjacent second N-type silicon layers 320.

In addition, the first N-type silicon layer 310 and the second N-type silicon layers 320 prepared by PECVD are not only continuous and have good compactness, but also have excellent impurity absorption, impurity blocking and field passivation and high electron selective permeability.

In addition, when preparing the N-type silicon layer 300, other gases can also be introduced to enhance passivation or play a role in impurity blocking.

In one embodiment, step S200 further includes: S230, a concentration of silane introduced during the formation of the first N-type silicon layer 310 is the same as the concentration of silane introduced during the formation of the second N-type silicon layer 320. As such, the silane concentration in the first N-type silicon layer 310 is the same as the silane concentration in the second N-type silicon layer 320, which meets the performance requirements, and the introduction of silane can also enhance passivation or play a role in impurity blocking. Furthermore, the silane concentration is greater than the phosphine concentration of the first N-type silicon layer 310, and the silane concentration is less than the phosphine concentration of the second N-type silicon layer 320, such that both the first N-type silicon layer 310 and the second N-type silicon layer 320 can bind hydrogen atoms, and the binding capacity of the second N-type silicon layer 320 relatively adjacent to the outer side is stronger, thus ensuring that hydrogen atoms in all parts can be bound, and the film explosion can be effectively avoided.

Optionally, a silane of greater than or equal to 1200 sccm and less than or equal to 1800 sccm is introduced, such that the silane concentration of the first N-type silicon layer 310 is the same as the silane concentration of the second N-type silicon layer 320, and the silane concentration is greater than the phosphine concentration of the first N-type silicon layer 310, and the silane concentration is less than the phosphine concentration of the second N-type silicon layer 320.

In one embodiment, step S230 further includes: S231, methane is introduced, and a methane concentration is less than or equal to three times of the silane concentration. As such, the introduction of methane enables carbon to be doped, so as to reduce the crystalline quality of polycrystalline silicon, thus reducing the residual stress during the high-temperature annealing process, and the formation of C-Si bonds improves the strength of the chemical bond, together inhibit frothing and film explosion. In addition, the formation of C-H bonds facilitates the suppression of the release level of hydrogen, such that the ability of carbon to capture hydrogen atoms is strengthened, and the film explosion caused by escape of hydrogen atoms is inhibited.

The amount of methane introduced can be flexibly designed or adjusted according to the actual use requirements, as long as the methane concentration is less than or equal to three times of the silane concentration, so as to further avoid the film explosion.

It should be noted that in the aforementioned embodiments of process for producing the cell piece, the introduction of silane and the introduction of phosphine can be performed simultaneously or separately, which is not limited herein.

In addition, it should be explained that the phosphine concentration of the N-type silicon layer 300 refers to the phosphine content in the N-type silicon layer 300; the phosphine concentration of the first N-type silicon layer 310 refers to the phosphine content in the first N-type silicon layer 310; the phosphine concentration of the second N-type silicon layer 320 refers to the phosphine content in the second N-type silicon layer 320; the silane concentration of the first N-type silicon layer 310 refers to the silane content in the first N-type silicon layer 310; and the silane concentration of the second N-type silicon layer 320 refers to the silane content in the second N-type silicon layer 320.

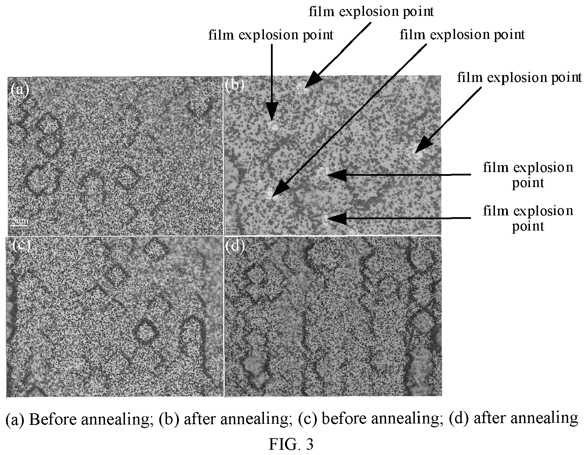

As shown in FIG. 3 (c) and (d), when a cell piece produced by the production process according to the aforementioned embodiments is observed under microscope, there is no film explosion. While a cell piece produced by the conventional production process is observed under microscope, as shown in FIG. 3 (a) and (b), there is a film explosion problem.

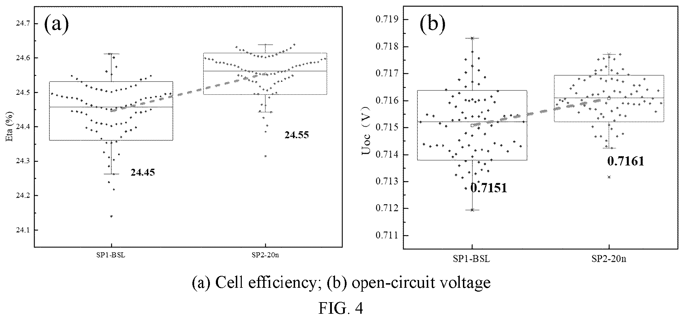

In addition, as shown in FIG. 4, by adjusting the phosphine concentration of the first N-type silicon layer 310, the film explosion problem can be completely solved, and both the cell efficiency and open-circuit voltage are significantly improved after solving the film explosion problem. SP1 refers to the cell efficiency and open-circuit voltage of a cell piece produced by conventional method, and SP2 refers to the cell efficiency and open-circuit voltage of a cell piece produced by the production process according to the embodiments of the present disclosure.

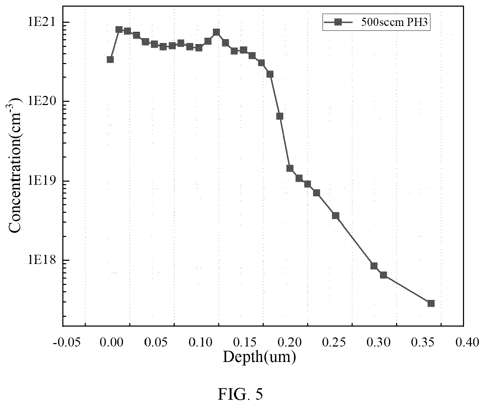

In addition, in the production process according to the embodiments of the present disclosure, after replacing the intrinsic polycrystalline silicon layer by the low-doped first N-type silicon layer 310, without changing other process conditions, it can be inferred from the ECV (Electrochemical capacitance-voltage profiler) test that the overall thickness of the cell piece increases by about 10 nm to 30 nm. The ECV of the cell with a phosphine concentration of 500 sccm using the production method according to the embodiments of the present disclosure is shown in FIG. 5.

It should be noted that the preparation temperature of the silicon oxide layer 200, the N-type silicon layer 300 and the anti-reflection layer 400 can be flexibly designed or adjusted according to the respective process conditions or process requirements. For example, the temperature of preparing the first N-type silicon layer 310 and the second N-type silicon layer 320 may be 80°C to 380°C. In addition, the size and specific shape specifications of the N-type silicon wafer 100 are not limited herein.

The process for producing cell piece in the aforementioned embodiments has at least the following advantages: 1. hydrogen atoms can be bound in the high-temperature annealing process, such that the film explosion caused by escape of hydrogen atoms can be avoided; 2. the binding capacity to hydrogen atoms is continuously strengthened from the inside to the outside, such that the hydrogen atoms can be effectively bound in all parts, thus effectively avoiding the film explosion; 3. the open-circuit voltage, the conversion efficiency (the average increase of the conversion efficiency can be 24.67% or more) and the filling factor can be increased, and the back-passivation effect can also be improved, thus the quality of the cell piece is improved.

As shown in FIG. 6, in one embodiment, a cell piece obtained by the production process according to any one of the aforementioned embodiments is provided.

There is no film explosion problem in the cell pieces of the aforementioned embodiments, the product quality is high. In addition, the open-circuit voltage, the conversion efficiency and the filling factor are all high.

As shown in FIG. 6, in one embodiment, a cell piece includes an N-type silicon wafer 100, a silicon oxide layer 200, and an N-type silicon layer 300. The N-type silicon wafer 100 has backside, and the silicon oxide layer 200 is provided on the backside. The N-type silicon layer 300 is provided on a side of the silicon oxide layer 200 away from the N-type silicon wafer 100, and a phosphine concentration of the N-type silicon layer 300 is within a first preset concentration range, so as to bind hydrogen atom during a high-temperature annealing process. As such, in the subsequent high-temperature annealing process, since the N-type silicon layer 300 is doped with a certain concentration of phosphine, hydrogen atoms can be bound, and the film explosion caused by spillage and diffusion due to escape of hydrogen atoms can be avoided. Therefore, not only the open-circuit voltage, the conversion efficiency and the filling factor can be increased, but also the back-passivation effect can be improved, thereby improving the quality of the cell piece.

As shown in FIG. 6, the N-type silicon layer further includes a first N-type silicon layer 310 and a second N-type silicon layer 320. The first N-type silicon layer 310 is provided on the side of the silicon oxide layer 200 away from the N-type silicon wafer 100. The second N-type silicon layer 320 is provided on a side of the first N-type silicon layer 310 away from the silicon oxide layer 200. Both a phosphine concentration of the first N-type silicon layer 310 and a phosphine concentration of the second N-type silicon layer 320 are within the first preset concentration range. As such, in the subsequent high-temperature annealing process, since both the first N-type silicon layer 310 and the second N-type silicon layer 320 are doped with a certain concentration of phosphine, hydrogen atoms can be bound, and the film explosion caused by spillage and diffusion due to escape of hydrogen atoms can be avoided. Therefore, the open-circuit voltage, the conversion efficiency and the filling factor can be increased, thereby improving the quality of the cell piece. In addition, the phosphine concentration of the second N-type silicon layer 320 is greater than the phosphine concentration of the first N-type silicon layer 310, hydrogen atoms can be well bound, thus ensuring that hydrogen atoms will not escape and cause spillage and diffusion, thereby effectively avoiding the film explosion.

The phosphine concentration of the first N-type silicon layer increases in a direction of thickness away from the silicon oxide layer. As such, when preparing the first N-type silicon layer 310 by PECVD or other methods, the thickness of the first N-type silicon layer 310 increases as the time goes by, and the phosphine concentration also increases simultaneously, such that the phosphine concentration of the first N-type silicon layer 310 away from the silicon oxide layer 200 is greater than the phosphine concentration of the first N-type silicon layer 310 adjacent to the silicon oxide layer 200. Therefore, the binding capacity of the first N-type silicon layer 310 to hydrogen atoms is continuously enhanced in a direction away from the silicon oxide layer 200 (as direction A shown in FIG. 6), thus ensuring that all parts of the first N-type silicon layer 310 can effectively bind hydrogen atoms, and the film explosion can be effectively avoided.

The phosphine concentration of the second N-type silicon layer increases in a direction of thickness away from the silicon oxide layer. As such, when preparing the second N-type silicon layer 320 by PECVD or other methods, the thickness of the second N-type silicon layer 320 increases as the time goes by, and the phosphine concentration also increases simultaneously, such that the phosphine concentration of the second N-type silicon layer 320 away from the first N-type silicon is greater than the phosphine concentration of the second N-type silicon layer 320 adj acent to the first N-type silicon. Therefore, the binding capacity of the second N-type silicon layer 320 to hydrogen atoms is continuously enhanced in a direction away from the first N-type silicon (as direction A shown in FIG. 6), thus ensuring that all parts of the second N-type silicon layer 320 can effectively bind hydrogen atoms, and the film explosion can be effectively avoided.

In one embodiment, a solar cell panel including the cell piece according to any one of the aforementioned embodiments is provided.

There is no film explosion problem in the solar cell panel of the aforementioned embodiments, the product quality is high. In addition, the open-circuit voltage, the conversion efficiency and the filling factor are all high.

It should be noted that "a body" and "a part" may be a part of the respective "component", that is, "a body" and "a part" are integrally formed with "other parts of component"; they may also be an independent component that is separable from "other parts of component", that is, "a body" and "a part" may be manufactured independently, and then combined with "other parts of component" into a whole. The above expression "a body" and "a part" in the present disclosure is only one of the embodiments, it is to facilitate reading, but not to limit the scope of protection of the present disclosure, as long as contains the above features and has the same function, it should be understood as equivalent to the technical solutions of the present disclosure.

It should be noted that in the present disclosure, components included in "unit", "assembly", "mechanism" and "device" can also be flexibly combined, that is, modular production can be carried out according to actual needs to facilitate modular assembly. The division of the above components in the present disclosure is only one of the embodiments, it is to facilitate reading, but not to limit the scope of protection of the present disclosure, as long as contains the above components and has the same function, it should be understood as equivalent to the technical solutions of the present disclosure.

In the description of the present disclosure, it should be understood that terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial" , "circumferential", etc. indicate an orientation or a positional relationship based on an orientation or a positional relationship shown in the drawings, which is only for the purpose of facilitating and simplifying the description of the present disclosure, rather than indicates or implies that the device or elements must have a specific orientation, be constructed and operated in a specific orientation, and therefore cannot be construed as limitation of the present disclosure. The term "and/or" used herein includes any and all combinations of one or more of the associated listed items.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one of the features. In the description of the present disclosure, "plurality" means at least two, such as two, three, etc., unless otherwise specifically defined.

In the present disclosure, the terms "mounting," "connecting together," "connecting," "fixing" and the like should be understood broadly. For example, it could be understood as a fixed connection, a detachable connection, or an integrated connection; it could be understood as a mechanical connection or an electrical connection; it could be understood as a direct connection or an indirect connection by an intermediate medium; and it could be understood as an internal communication between two elements or an interaction between two elements, unless otherwise expressly defined. For those who skill in the art, the specific meaning of the aforementioned terms in the present disclosure can be understood according to specific situations.

In the present disclosure, unless expressly stipulated and defined otherwise, the first feature "on" or "under" the second feature may refer to that the first and second features are in direct contact, or the first and second features are in indirectly contact through an intermediary. Moreover, the first feature "above" or "over" the second feature may refer to that the first feature is directly above or obliquely above the second feature, or refer to that the height of the first feature is greater than the height of the second feature. The first feature "below" or "under" the second feature may refer to that the first feature is directly below or obliquely below the second feature, or refer to that that the height of the first feature is less than the second feature.

It should be noted that when an element is defined as "fixed", "disposed", "fastened" or "mounted" on another element, it is either directly on an element or indirectly on an element with a mediating element. When one element is considered to be "connected to" another element, the element may be directly connected to another element or there may be an intermediate element therebetween. Furthermore, when one element is considered to be a "fixed transmission connection" to another element, the two can be fixed in a removable connection, or fixed in a non-removable connection, as long as achieving the power transmission, such as socketing, clamping, integrally formation fixation, welding, etc., which can be realized in the prior art, and will not be repeated herein. When an element and the other element are perpendicular or nearly perpendicular to each other, it means that the ideal state of the two is perpendicular, but due to the influence of manufacturing and assembly, there can be a certain vertical error. The terms "vertical", "horizontal", "left", "right", and the like used herein are for illustrative purposes only and are not intended to be the only example. The term "and/or" used herein includes any and all combinations of one or more of the associated listed items.

It should also be understood that, when interpreting connectivity or positional relationships of elements, although not explicitly described, connectivity and positional relationships are interpreted as including an error range, which should be within the acceptable deviation range of the specific value determined by those skilled in the art. For example, "about", "approximately" or "substantially" may mean within one or more standard deviations, which is not limited herein.

Each of the technical features of the above-mentioned examples may be combined arbitrarily, to simplify the description, not all the possible combinations of each of the technical features in the above examples are described, however, all of the combinations of these technical features should be considered as within the scope of this disclosure, as long as such combinations do not contradict with each other.

The above embodiments merely illustrate several embodiments of the present disclosure, and the description thereof is specific and detailed, but it shall not be constructed as limiting the scope of the present disclosure. It should be noted that a plurality of variations and modifications may be made by those skilled in the art without departing from the scope of this disclosure, which are all within the scope of protection of this disclosure. Therefore, the protection scope of this disclosure shall be subject to the appended claims.

## Claims

1. A process for producing a cell piece, comprising the following steps:
forming a silicon oxide layer on a backside of an N-type silicon wafer;
forming an N-type silicon layer on the silicon oxide layer, wherein a phosphine concentration of the N-type silicon layer is within a first preset concentration range; and
forming an anti-reflection layer on the N-type silicon layer and forming a backside electrode on the anti-reflection layer.

2. The process for producing the cell piece according to claim 1, wherein the step of forming the N-type silicon layer on the silicon oxide layer comprises:
forming a first N-type silicon layer on the silicon oxide layer, wherein a phosphine concentration of the first N-type silicon layer is within the first preset concentration range; and
forming a second N-type silicon layer on the first N-type silicon layer, wherein a phosphine concentration of the second N-type silicon layer is within the first preset concentration range, and the phosphine concentration of the second N-type silicon layer is greater than the phosphine concentration of the first N-type silicon layer.

3. The process for producing the cell piece according to claim 2, wherein the step of forming the second N-type silicon layer on the first N-type silicon layer comprises:
wherein the phosphine concentration of the second N-type silicon layer is at least twice the phosphine concentration of the first N-type silicon layer.

4. The process for producing the cell piece according to claim 2, wherein the step of forming the first N-type silicon layer on the silicon oxide layer, wherein the phosphine concentration of the first N-type silicon layer is within the first preset concentration range comprises: introducing a phosphine of less than or equal to 1000 sccm.

5. The process for producing the cell piece according to claim 4, wherein the step of forming the first N-type silicon layer on the silicon oxide layer, wherein the phosphine concentration of the first N-type silicon layer is within the first preset concentration range comprises: introducing a phosphine of greater than or equal to 500 sccm and less than or equal to 1000 sccm.

6. The process for producing the cell piece according to any one of claims 2 to 5, wherein the step of forming the second N-type silicon layer on the silicon oxide layer, wherein the phosphine concentration of the second N-type silicon layer is within the first preset concentration range, and the phosphine concentration of the second N-type silicon layer is greater than the phosphine concentration of the first N-type silicon layer comprises: introducing a phosphine of greater than or equal to 2000 sccm.

7. The process for producing the cell piece according to claim 6, wherein the step of forming the second N-type silicon layer on the silicon oxide layer, wherein the phosphine concentration of the second N-type silicon layer is within the first preset concentration range, and the phosphine concentration of the second N-type silicon layer is greater than the phosphine concentration of the first N-type silicon layer comprises: introducing a phosphine of greater than or equal to 2500 sccm.

8. The process for producing the cell piece according to claim 2, wherein the step of forming the first N-type silicon layer on the silicon oxide layer, wherein the phosphine concentration of the first N-type silicon layer is within the first preset concentration range comprises: wherein the phosphine concentration of the first N-type silicon layer increases with an increase in a thickness of the first N-type silicon layer.

9. The process for producing the cell piece according to any one of claims 2 to 8, wherein the step of forming the second N-type silicon layer on the silicon oxide layer, wherein the phosphine concentration of the second N-type silicon layer is within the first preset concentration range, and the phosphine concentration of the second N-type silicon layer is greater than the phosphine concentration of the first N-type silicon layer comprises: wherein the phosphine concentration of the second N-type silicon layer increases with an increase in a thickness of the second N-type silicon layer.

10. The process for producing the cell piece according to any one of claims 2 to 9, wherein the step of forming the N-type silicon layer on the silicon oxide layer, wherein the phosphine concentration of the N-type silicon layer is within the first preset concentration range comprises:
wherein a concentration of silane introduced during the formation of the first N-type silicon layer is the same as a concentration of silane introduced during the formation of the second N-type silicon layer, the silane concentration is greater than the phosphine concentration of the first N-type silicon layer, and the silane concentration is less than the phosphine concentration of the second N-type silicon layer.

11. The process for producing the cell piece according to claim 10, wherein the step of forming the N-type silicon layer on the silicon oxide layer comprises:
introducing the silane of greater than or equal to 1200 sccm and less than or equal to 1800 sccm.

12. The process for producing the cell piece according to claim 10, wherein the step of the concentration of silane introduced during the formation of the first N-type silicon layer is the same as the concentration of silane introduced during the formation of the second N-type silicon layer further comprises: introducing methane, wherein a methane concentration is less than or equal to three times of the silane concentration.

13. A cell piece produced using the production process according to any one of claims 1 to 12.

14. The cell piece according to claim 13, comprising:
an N-type silicon wafer having a backside;
a silicon oxide layer provided on the backside; and
an N-type silicon layer provided on a side of the silicon oxide layer away from the N-type silicon wafer, wherein a phosphine concentration of the N-type silicon layer is within a first preset concentration range, so as to bind hydrogen atom during a high-temperature annealing process.

15. The cell piece according to claim 14, wherein the N-type silicon layer comprises a first N-type silicon layer and a second N-type silicon layer, the first N-type silicon layer is provided on the side of the silicon oxide layer away from the N-type silicon wafer, the second N-type silicon layer is provided on a side of the first N-type silicon layer away from the silicon oxide layer, both a phosphine concentration of the first N-type silicon layer and a phosphine concentration of the second N-type silicon layer are within the first preset concentration range, and the phosphine concentration of the second N-type silicon layer is greater than the phosphine concentration of the first N-type silicon layer.

16. The cell piece according to claim 15, wherein the phosphine concentration of the first N-type silicon layer increases in a direction of thickness away from the silicon oxide layer.

17. The cell piece according to claim 15 or 16, wherein the phosphine concentration of the second N-type silicon layer increases in a direction of thickness away from the first N-type silicon layer.

18. A solar cell panel, comprising the cell piece according to any one of claims 13 to 17.
